(19) Europäisches Patentamt
European Patent Office
Office européen des brevets

(11) **EP 2 608 409 B1**

(12) # EUROPEAN PATENT SPECIFICATION

(45) Date of publication and mention
of the grant of the patent:
**22.04.2015 Bulletin 2015/17**

(51) Int Cl.:
***H03H 17/06*** (2006.01)

(21) Application number: **11194460.9**

(22) Date of filing: **20.12.2011**

(54) **Multichannel sample rate converter**

Mehrkanaliger Abtastratenwandler

Convertisseur de taux d'échantillonnage multicanaux

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(43) Date of publication of application:
**26.06.2013 Bulletin 2013/26**

(73) Proprietor: **Televic Conference NV
8870 Izegem (BE)**

(72) Inventor: **Melange, Cedric
8800 Beveren (Roeselare) (BE)**

(74) Representative: **Van Bladel, Marc et al
DenK iP bvba
Hundelgemsesteenweg 1114
9820 Merelbeke (BE)**

(56) References cited:
**US-A- 5 986 589          US-A1- 2003 161 477
US-A1- 2007 046 503     US-A1- 2011 054 913**

**Description**

**Field of the invention**

The present invention is related to the field of devices and methods for sample rate conversion of digital data streams, in particular audio or video streams.

**Background of the invention**

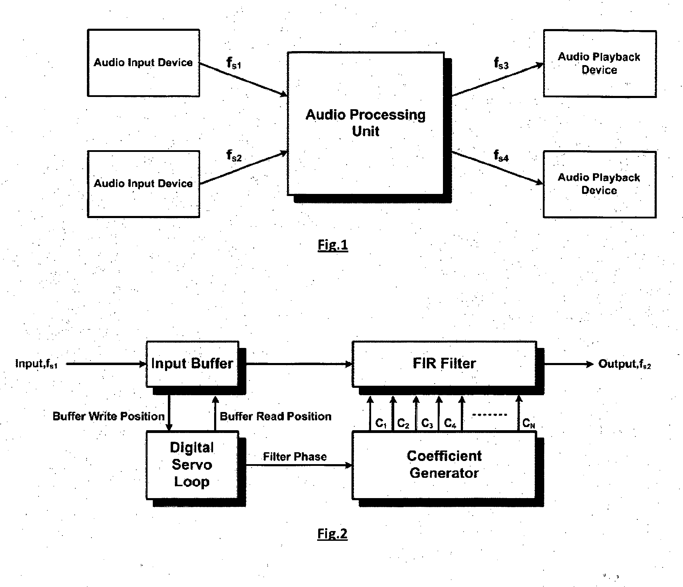

Digital sampling of analog signals such as audio signals or video signals is generally known. When processing the sampled signals it is often desirable to mix sampled data having different sample rates. For example, when several input and playback audio devices that each operate at an own independent sample rate, are connected to an audio processing device as shown in Fig.1, some kind of synchronization and resampling of the audio streams has to be performed by the audio processing unit. Hence, the audio processing unit must be capable of performing a sample rate conversion in which the sampled signal is converted from a first sample rate to a second sample rate.

Fig.2 depicts the general structure of a prior art (asynchronous) audio resampler/synchronizer. Next to an input buffer one can distinguish two main building blocks. A finite impulse response (FIR) filter with coefficient generator can delay (phase shift) the audio stream by a certain amount dictated by the information on the filter phase input. The second block is the digital servo loop. This is a feedback control loop circuit that tries to null the difference between the input and the output sampling phase by controlling the delay of the FIR filter.

However, when implementing multichannel applications, prior art solutions suffer from the important drawback that each independent data stream needs its own complete synchronizer.

Patent application US2011/211658 discloses a solution for performing digital multi-channel decoding of a BTCS (Broadcast Television System Committee) composite audio signal. Each subsequent stage of the digital multi-channel decoding process is performed at the lowest sampling rate that yields acceptable performance for that stage. Analog-to-digital conversion of the composite audio signal is performed first to generate a composite digital audio signal. After analog-to-digital conversion, all signal processing may be performed in the digital domain. The composite digital audio signal is digitally filtered to frequency compensate for variations caused by previous stages of processing, including IF demodulation. Digital channel demodulation and filtering are performed to isolate single channels of the composite digital audio signal.

Document US 2011/0054913 discloses a multichannel sample rate converter according to the prior art.

**Summary of the invention**

It is an object of embodiments of the present invention to provide for a sample rate converter that can be shared by independent input data streams with a different sample rate.

The above objective is accomplished by a sample rate conversion system according to the present invention. The system for sample rate conversion of an input stream of digital data among a plurality of input streams sampled at a different input rate to obtain an output stream with an output sample rate comprises

- storage means for storing input samples of the plurality of input streams,
- controller means adapted for receiving activation signalling related to the input streams and for outputting an indication of sampling instants for the output stream at the output sampling rate,
- resampling means arranged for receiving input samples from the storage means and for filtering the received input samples with an adaptive set of filter coefficients to produce an output stream at an output rate.

The system comprises a selector means arranged for receiving the activation signalling related to the input streams, for selecting among the input streams an input stream to be sample rate converted, wherein said selector means is arranged for outputting a signal indicative of the selected input stream and for outputting signalling for selecting the corresponding indication of sampling instants, so that filter coefficients for performing resampling in said resampling means can be generated.

Due to the selector means various input streams with different input rate can be dealt with. The selector contains the circuitry necessary for performing an algorithm for deciding on which data stream will be treated next and for exporting the signalling needed to obtain the information to perform the sample rate conversion for the selected input data stream. More in particular, an indication of the sampling instants for the output stream at the output sampling rate is needed for performing the actual sample rate conversion.

In a preferred embodiment the storage means comprises separate buffering means per input stream. The signal indicative of the selected input stream advantageously comprises an indication of a starting address for storing samples of the selected stream in the storage means.

In one embodiment the system comprises latching means for latching the indication of the sampling instants during a filtering operation. In this way further incoming activation signals have to wait before being treated by the selector means until an on-going filtering operation has been completed.

Advantageously the resampling means comprises a coefficient generator arranged for receiving the signal indicative of the selected input stream and of the sampling instants. The coefficient generator block is preferably arranged for adapting the filter bandwidth. This may be advantageous e.g. in order to avoid aliasing when a downsampling operation is to be performed.

In another embodiment the system comprises an additional filter for performing a prefiltering operation on the input samples from the storage means prior to applying them to the resampling means. This is an alternative to changing the filter bandwidth.

In an embodiment of the invention the controller means comprises a separate control block per different input rate.

In a preferred embodiment the selector means is arranged for operating on the input streams on a first come, first served basis. Other algorithms for deciding on the next input data stream to be sample rate converted can however be envisaged. Examples include but are not limited to round robin algorithms, random, fastest sample rate first, ....

In a particular embodiment of the invention the number of different sample rates of the plurality of input streams equals 2. In case the output rate can adopt the same two sample rate values as the sample rates at the input, an advantageous design can be obtained, wherein also a single control means is shared by the two input data streams.

The selector means is in a preferred embodiment arranged for outputting a filter enable signal to the resampling means.

The invention also relates to a delegate unit of a digital conference system, comprising a system as previously described.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

## Brief description of the drawings

The invention will now be described further, by way of example, with reference to the accompanying drawings, in which:

Fig.1 represents a typical scenario wherein there is a need for sample rate conversion.
Fig.2 represents a resampling scheme as known in the prior art.
Fig.3 represents an architecture of a low footprint multichannel audio synchronizer according to an embodiment of the present invention.
Fig.4 represents a centralized conference system wherein bidirectional asynchronous sample rate converters are needed.
Fig.5 represents a specific embodiment of the invention illustrating an architecture of a low footprint multichannel bidirectional audio synchronizer.

## Detailed description of illustrative embodiments

The present invention will be described with respect to particular embodiments and with reference to certain drawings but the invention is not limited thereto but only by the claims.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being redefined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

The present invention proposes a sample rate conversion system with an architecture comprising a shared memory block, a shared finite impulse response (FIR) filter to carry out the resampling and a selector means, below also referred to as an arbitrator.

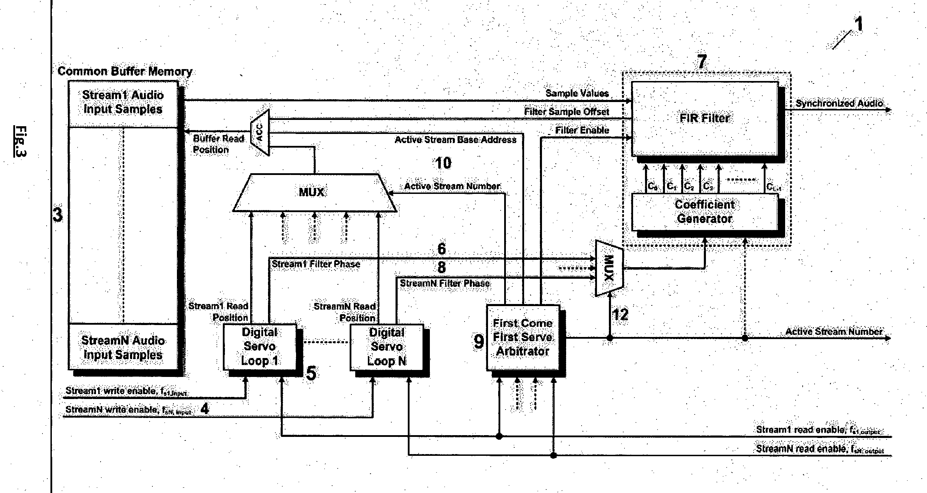

Fig.3 illustrates a first possible implementation of the multichannel sample rate conversion system according to the invention.

Apart from a shared buffer memory (3) and FIR filter (7), the embodiment of Fig.3 shows an arbitrator (9) operable according to the first come first served principle. As controller means a separate digital servo loop (5) is provided per audio stream. The buffer memory can either be implemented as an external storage means or can be integrated to form a single audio synchronizer device.

The common input buffer (3) is divided in N areas (with N the number of audio streams that need synchronization), each starting at a stream base address. Each area is used as a circular buffer for the input audio samples. In the embodiment shown in Fig.3 the activation signalling comprises a read enable and a write enable signal per stream. Each synchronizing operation is initiated by the activation of a stream read enable. According to the arrival time of the different read enable assertions, the arbitrator (9) assigns the shared synchronizer blocks to a certain active stream, employing a first-come-first-served principle. This is the simplest form of arbitration, but obviously other forms of arbitration to select the active stream can be implemented for this purpose. The digital servo loops are not controlled by the arbitrator and continuously output their stream read position and stream filter phase based on the write enable and read enable outputs. In more general terms the digital servo loops output an indication of the position in the input stream that corresponds to the current output sampling time. This position has a higher resolution than the input sampling clock and in the displayed embodiment this quantity is conveniently formatted as a sampling phase.

The arbitrator enables the FIR filter each time it receives a read enable from an output stream. When different read enables follow too shortly on each other for the filter to finish the processing of the requested sample, the read enables are delayed by the arbitrator, so that all requests are correctly processed in a sequential way. This mechanism acts as a scheduler.

To further avoid problems when a second read enable comes before the resampling filter operation is terminated, these values can be latched the moment the arbitrator enables the FIR filter. Based on the active stream number selected by the arbitrator, read position and filter phase corresponding to this active stream are selected by means of a multiplexer. Optionally the coefficient generator can change the filter bandwidth for this particular active stream, e.g. to avoid aliasing when downsampling is required. An alternative for having to change the bandwidth of the resampling filter is prefiltering before the synchronization. When the multiplexers are switched, the arbitrator starts the filter operation by enabling the FIR filter. The memory address of the input audio samples needed by the FIR filter to calculate the current output sample is calculated as the sum of the active stream base address (BA) and the circular buffer address of the active stream read position (RP) decreased by the filter offset(FO). The output of the L-tap FIR filter is then determined as

$$Filter_{out} = \sum_{FO=0}^{L-1} C[FO] * input\_buf[BA + circ(RP - FO)]$$

where C[x] denote the filter coefficients generated by the coefficient generator. The advantage of the invented architecture is that a single memory block and infrastructure as well as the FIR filter and coefficient generator can be shared among the different audio streams, resulting in a small hardware footprint.

In the embodiment presented in Fig.3 a FIR filter is used as a hardware efficient means to interpolate the input stream. This hardware block is however not restricted to this exact type of interpolator. Other interpolation hardware, like polynomial interpolators can be used to build the invention.

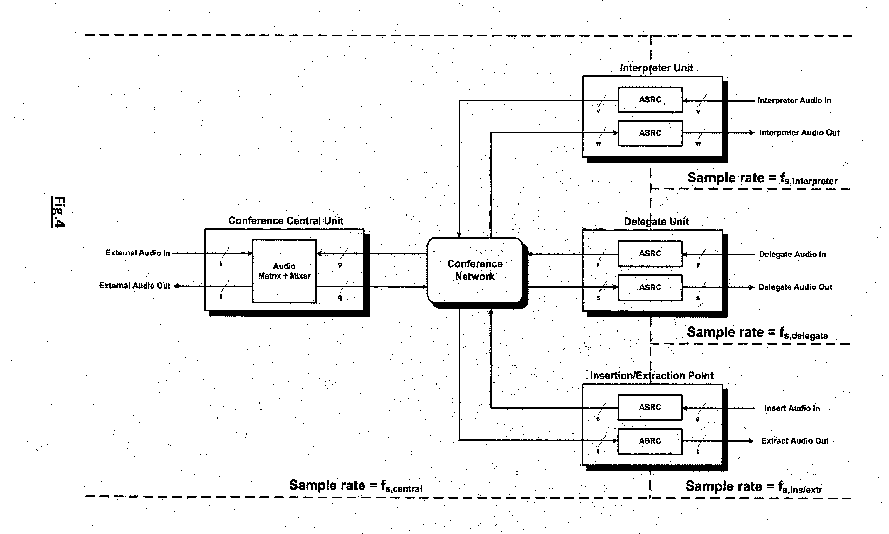

In the special case of bidirectional sample rate conversion, where one group of channels is synchronized from a certain source frequency $f_{source}$ to a destination frequency $f_{destination}$ and another is synchronized in the opposite direction from $f_{destination}$ to $f_{source}$, even the controller (implemented e.g. as a servo loop as before) can be shared among the two groups. An example of such a situation is a centralized conference system as sketched in Fig.4.

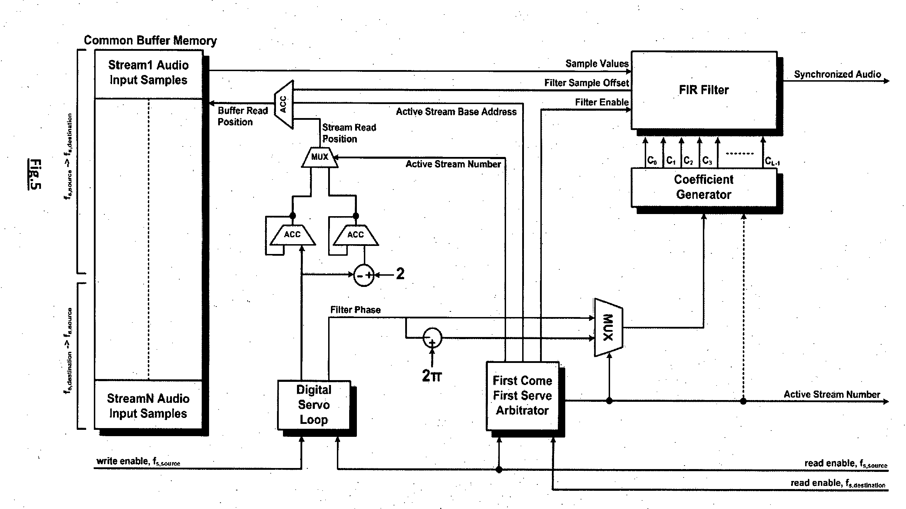

Indeed, a delegate unit has to be able to listen to audio coming from the central conference unit sampled at $f_{s,central}$ and played back by an audio codec at the local sample rate $f_{s,delgate}$ and at the same time be able to send audio/speech to the central conference unit. To cross the different clock domains, a bidirectional asynchronous sample rate converter can be placed in the delegate unit and other peripheral units. Fig.5 shows the architecture of such bidirectional audio synchronizer. The arbitrator here groups all the audio streams that need synchronization in one direction. This means that when for example the read enable at sample rate $f_{s,destination}$ is asserted, all the audio streams that are converted from $f_{s,source}$ to $f_{s,destination}$ are processed in a sequential and uninterrupted manner. The filter phase is derived from a single servo loop, by noting that the phases of both conversions rotate at the same speed, but in the opposite direction. The phase of the second direction $\varphi_2$ can be derived from the phase of the first direction $\varphi_1$ as

$$\varphi_2 = 2\pi - \varphi_1$$

The active stream read position for both conversion directions can also be determined by a single servo loop. When a sample is dropped in one direction, a sample will have to be duplicated in the other and vice versa. For equal nominal sample rates $f_{s,source}$ and $f_{s,destination}$ the idea leads to the simple implementation in Fig.5. The general idea, however, can be extended to any ratio of the sample rates.

In another embodiment of the invention a combination of the architectures shown in Fig3 and in Fig.5 is made. The synchronizer then processes several bidirectional audio streams with a single controller together with some independent audio streams, each with its own servo loop, at a minimum hardware cost.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments, but sotely by the appended claims.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

**Claims**

1.    System (1) for sample rate conversion of an input stream of digital data among a plurality of input streams sampled at a different input sample rate to obtain an output stream with an output sample rate, said system comprising

- storage means (3) for storing input samples of said plurality of input streams,
- controller means (5) arranged for receiving activation signalling (4) related to said input streams and for outputting for said input streams an indication (6,8) of sampling instants for said output stream at said output sampling rate,
- resampling means (7) arranged for receiving input samples from said storage means and for filtering the received input samples with an adaptive set of filter coefficients to produce said output stream at said output rate,

wherein the system comprises a selector means (9) arranged for receiving said activation signalling related to said input streams, for selecting among said input streams an input stream to be sample rate converted, said selector means being arranged for outputting a signal (10) indicative of said selected input stream and for outputting signalling (12) for selecting the corresponding indication of sampling instants, so that filter coefficients for performing resampling in said resampling means can be generated.

2. System for sample rate conversion as in claim 1, wherein said storage means comprises separate buffering means per input stream.

3. System for sample rate conversion as in claim 1 or claim 2, wherein said signal indicative of said selected input stream comprises an indication of a starting address for storing samples of said selected stream in said storage means.

4. System for sample rate conversion as in any of claims 1 to 3, comprising latching means for latching said indication of said sampling instants during a filtering operation.

5. System for sample rate conversion as in any of claims 1 to 4, wherein said resampling means comprises a coefficient generator block arranged for receiving said signal indicative of said selected input stream and of said sampling instants.

6. System for sample rate conversion as in claim 5, wherein said coefficient generator block is arranged for adapting the filter bandwidth.

7. System for sample rate conversion as in any of claims 1 to 5, comprising an additional filter for performing a prefiltering operation on the input samples from said storage means prior to applying them to said resampling means.

8. System for sample rate conversion as in any of the previous claims, wherein said controller means comprise a separate control block per different input rate.

9. System for sample rate conversion as in any of the previous claims, wherein said selector means is arranged for operating on said plurality of input streams on a first come, first served basis.

10. System for sample rate conversion as in any of the previous claims, wherein the number of different sample rates of said plurality of input streams equals 2 and wherein said output rate can adopt the same two sample rate values.

11. System for sample rate conversion as in any of the previous claims, wherein said selector means (9) is arranged for outputting a filter enable signal to said resampling means (7).

12. Delegate unit of a digital conference system, comprising a system as in any of the previous claims.

**Patentansprüche**

1. System (1) zur Abtastratenumsetzung eines Eingangsstroms digitaler Daten von mehreren Eingangsströmen, die mit einer verschiedenen Eingangsabtastrate abgetastet werden, um einen Ausgangsstrom mit einer Ausgangsabtastrate zu erhalten, wobei das System Folgendes umfasst:

- ein Speichermittel (3) zum Speichern von Eingangsabtastwerten der mehreren Eingangsströme,
- ein Steuerungsmittel (5), ausgelegt zum Empfangen von Aktivierungssignalisierung (4) in Bezug auf die Eingangsströme und zum Ausgeben einer Angabe (6, 8) von Abtastmomenten für den Ausgangsstrom mit der Ausgangsabtastrate für die Eingangsströme,

- ein Umabtastungsmittel (7), ausgelegt zum Empfangen von Eingangsabtastwerten aus Speichermitteln und zum Filtern der empfangenen Eingangsabtastwerte mit einer adaptiven Menge von Filterkoeffizienten, um den Ausgangsstrom mit der Ausgangsrate zu produzieren,

wobei das System ein Selektormittel (9) umfasst, ausgelegt zum Empfangen der Aktivierungssignalisierung in Bezug auf die Eingangsströme, zum Auswählen eines abtastratenumzusetzenden Eingangsstroms aus den Eingangsströmen, wobei das Selektormittel ausgelegt ist zum Ausgeben eines Signals (10), das den ausgewählten Eingangsstrom angibt, und zum Ausgeben von Signalisierung (12) zum Auswählen der entsprechenden Angabe von Abtastmomenten, so dass Filterkoeffizienten zum Durchführen einer Umabtastung in dem Umabtastungsmittel erzeugt werden können.

2. System zur Abtastratenumsetzung nach Anspruch 1, wobei das Speichermittel getrennte Pufferungsmittel pro Eingangsstrom umfasst.

3. System zur Abtastratenumsetzung nach Anspruch 1 oder Anspruch 2, wobei das Signal, das den ausgewählten Eingangsstrom angibt, eine Angabe einer Startadresse zum Speichern von Abtastwerten des ausgewählten Stroms in den Speichermitteln umfasst.

4. System zur Abtastratenumsetzung nach einem der Ansprüche 1 bis 3, das Haltespeichermittel zum Haltespeichern der Angabe der Abtastmomente während einer Filterungsoperation umfasst.

5. System zur Abtastratenumsetzung nach einem der Ansprüche 1 bis 4, wobei das Umabtastungsmittel einen Koeffizientengeneratorblock umfasst, ausgelegt zum Empfangen des Signals, das den ausgewählten Eingangsstrom und die Abtastmomente angibt.

6. System zur Abtastratenumsetzung nach Anspruch 5, wobei der Koeffizientengeneratorblock dafür ausgelegt ist, die Filterbandbreite anzupassen.

7. System zur Abtastratenumsetzung nach einem der Ansprüche 1 bis 5, das ein zusätzliches Filter zum Ausführen einer Vorfilterungsoperation an den Eingangsabtastwerten aus den Speichermitteln vor dem Anlegen dieser an das Umabtastungsmittel umfasst.

8. System zur Abtastratenumsetzung nach einem der vorhergehenden Ansprüche, wobei das Steuerungsmittel einen getrennten Steuerblock pro verschiedener Eingangsrate umfasst.

9. System zur Abtastratenumsetzung nach einem der vorhergehenden Ansprüche, wobei das Selektormittel ausgelegt ist zum Operieren an den mehreren Eingangsströmen, so dass der erste zuerst bedient wird.

10. System zur Abtastratenumsetzung nach einem der vorhergehenden Ansprüche, wobei die Anzahl verschiedener Abtastraten der mehreren Eingangsströme gleich 2 ist und wobei die Ausgangsrate dieselben zwei Abtastratenwerte annehmen kann.

11. System zur Abtastratenumsetzung nach einem der vorhergehenden Ansprüche, wobei das Selektormittel (9) dafür ausgelegt ist, ein Filterfreigabesignal an das Umabtastungsmittel (7) auszugeben.

12. Delegierungseinheit eines Digital-Konferenzsystems, das ein System nach einem der vorhergehenden Ansprüche umfasst.

**Revendications**

1. Un système (1) de conversion de taux d'échantillonnage d'un flux en entrée de données numériques parmi une pluralité de flux en entrée échantillonnés à un taux d'échantillonnage en entrée différent de façon à obtenir un flux en sortie avec un taux d'échantillonnage en sortie, ledit système comprenant

- un moyen de conservation en mémoire (3) pour la conservation en mémoire d'échantillons en entrée de ladite pluralité de flux en entrée,
- un moyen de dispositif de commande (5) agencé pour la réception d'une signalisation d'activation (4) relative auxdits flux en entrée et destiné à produire en sortie pour lesdits flux en entrée une indication (6, 8) d'instants d'échantillonnage pour ledit flux en sortie audit taux d'échantillonnage en sortie,
- un moyen de rééchantillonnage (7) agencé pour la réception d'échantillons en entrée à partir dudit moyen de conservation en mémoire et destiné au filtrage des échantillons en entrée reçus avec un ensemble adaptif de coefficients de filtre de façon à produire ledit flux en sortie audit taux en sortie,

où le système comprend un moyen de sélecteur (9) agencé de façon à recevoir ladite signalisation d'activation relative auxdits flux en entrée, pour la sélection parmi lesdits flux en entrée d'un flux en entrée destiné à être converti en termes de taux d'échantillonnage, ledit moyen de sélecteur étant agencé de façon à produire en sortie un signal (10) indicatif dudit flux en entrée sélectionné et de façon à produire en sortie une signalisation (12) pour la sélection de l'indication correspondante d'instants d'échantillonnage, de sorte que des coefficients de filtre destinés à l'exécution d'un rééchantillonnage dans ledit moyen de rééchantillonnage puissent être générés.

2. Le système de conversion de taux d'échantillonnage selon la Revendication 1, où ledit moyen de conservation en mémoire comprend un moyen de mise en mémoire tampon distinct par flux en entrée.

3. Le système de conversion de taux d'échantillonnage selon la Revendication 1 ou 2, où ledit signal indicatif dudit flux en entrée sélectionné comprend une indication d'une adresse de départ pour la conservation en mémoire d'échantillons dudit flux sélectionné dans ledit moyen de conservation en mémoire.

4. Le système de conversion de taux d'échantillonnage selon l'une quelconque des Revendications 1 à 3, comprenant un moyen de verrouillage destiné au verrouillage de ladite indication desdits instants d'échantillonnage au cours d'une opération de filtrage.

5. Le système de conversion de taux d'échantillonnage selon l'une quelconque des Revendications 1 à 4, où ledit moyen de rééchantillonnage comprend un bloc générateur de coefficients agencé de façon à recevoir ledit signal indicatif dudit flux en entrée sélectionné et desdits instants d'échantillonnage.

6. Le système de conversion de taux d'échantillonnage selon la Revendication 5, où ledit bloc générateur de coefficients est agencé pour l'adaptation de la bande passante de filtre.

7. Le système de conversion de taux d'échantillonnage selon l'une quelconque des Revendications 1 à 5, comprenant un filtre additionnel destiné à l'exécution d'une opération de préfiltrage sur les échantillons en entrée provenant dudit moyen de conservation en mémoire avant leur application audit moyen de rééchantillonnage.

8. Le système de conversion de taux d'échantillonnage selon l'une quelconque des Revendications précédentes, où ledit un moyen de dispositif de commande comprend un bloc de commande distinct par taux en entrée différent.

9. Le système de conversion de taux d'échantillonnage selon l'une quelconque des Revendications précédentes, où ledit moyen de sélecteur est agencé de façon à exploiter ladite pluralité de flux en entrée selon le principe premier arrivé, premier servi.

10. Le système de conversion de taux d'échantillonnage selon l'une quelconque des Revendications précédentes, où le nombre de taux d'échantillonnage différents de ladite pluralité de flux en entrée est égal à 2 et où ledit taux en sortie peut adopter les mêmes deux valeurs de taux d'échantillonnage.

11. Le système de conversion de taux d'échantillonnage selon l'une quelconque des Revendications précédentes, où ledit moyen de sélecteur (9) est agencé de façon à produire en sortie un signal d'activation de filtre vers ledit moyen de rééchantillonnage (7).

12. Une unité de participant à un système de conférence numérique comprenant un système selon l'une quelconque des Revendications précédentes.

**Fig.1**

**Fig.2**

Fig.3

Fig.4

11

**Fig.5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011211658 A
- US 20110054913 A